(19) Europäisches Patentamt

European Patent Office

Office européen des brevets

(11) Veröffentlichungsnummer: **0 213 425 B1**

(12) **EUROPÄISCHE PATENTSCHRIFT**

(45) Veröffentlichungstag der Patentschrift: **06.05.92**

(21) Anmeldenummer: **86110756.3**

(22) Anmeldetag: **04.08.86**

(51) Int. Cl.⁵: **H01L 27/06**

(54) **Integrierte Schaltung in komplementärer Schaltungstechnik mit einem Substratvorspannungs-Generator und einer Schottky-Diode.**

(30) Priorität: **26.08.85 DE 3530428**

(43) Veröffentlichungstag der Anmeldung:
**11.03.87 Patentblatt 87/11**

(45) Bekanntmachung des Hinweises auf die
Patenterteilung:
**06.05.92 Patentblatt 92/19**

(84) Benannte Vertragsstaaten:
**AT DE FR GB IT NL**

(56) Entgegenhaltungen:
**EP-A- 0 024 903       EP-A- 0 142 258
EP-A- 0 166 386       DE-A- 3 339 805
GB-A- 2 054 955       GB-A- 2 073 490**

**PATENT ABSTRACTS OF JAPAN, Band 8, Nr.
176 (E-260)[1613], 14. August 1984 & JP - A -
59 69956 (NIPPON DENKI K.K.) 20.04.1984**

(73) Patentinhaber: **SIEMENS AKTIENGESELL-
SCHAFT
Wittelsbacherplatz 2
W-8000 München 2(DE)**

(72) Erfinder: **Winnerl, Josef, Dr.-Ing.
Schubertstrasse 7
W-8300 Landshut(DE)**
Erfinder: **Takacs, Dezsö, Dipl.-Ing.
Annette-Kolb-Anger 7
W-8000 München 83(DE)**

**Beschreibung**

Die Erfindung bezieht sich auf eine integrierte Schaltung in komplementärer Schaltungstechnik mit einem Substratvorspannungs-Generator nach dem Oberbegriff des Patentanspruchs 1.

Bei Schaltungen dieser Art liegt das Halbleitersubstrat nicht auf dem Massepotential $V_{SS}$ der Schaltung, sondern auf einer Substratvorspannung $V_{BB}$, die mittels eines Substratvorspannungs-Generators erzeugt wird. Bei einem Halbleitersubstrat aus p-leitendem Material, das mit einer eingefügten n-leitenden wannenförmigen Halbleiterzone versehen ist, handelt es sich dabei um eine negative Substratvorspannung von etwa - 2 bis - 3 Volt. Die Source-Gebiete von Feldeffekttransistoren, die außerhalb der wannenförmigen Halbleiterzone auf dem Halbleitersubstrat vorgesehen sind, sind hierbei auf das Massepotential $V_{SS}$ gelegt. Ein derartiger Substratvorspannungs-Generator ist z.B. aus EP-A-0 024 903 bekannt.

Im Moment des Einschaltens der Versorgungsspannung $V_{DD}$ befindet sich das betrachtete p-leitende Halbleitersubstrat zunächst in einem Zustand des "floating", in dem es von äußeren Potentialen freigeschaltet ist. Dabei kann es über die Sperrschichtkapazitäten, die einerseits zwischen der wannenförmigen Halbleiterzone und dem Substrat und andererseits zwischen den mit dem Massepotential belegten Sourcegebieten und dem Substrat vorhanden sind, vorübergehend auf eine positive Vorspannung aufgeladen werden, die erst beim Wirksamwerden des Substratvorspannungs-Generators wieder abgebaut und durch die sich am Ausgang desselben allmählich aufbauende negative Substratvorspannung ersetzt wird. Aber auch im Betrieb der integrierten Schaltung können größere Ströme, die vom Halbleitersubstrat über den Substratvorspannungs-Generator zu einem auf Massepotential liegenden Anschluß des letzteren abgeleitet werden, durch den Spannungsabfall am Innenwiderstand des Substratvorspannungs-Generators zu einer positiven Vorspannung des Halbleitersubstrates führen. Positive Vorspannungen stellen aber ein hohes Sicherheitsrisiko für die integrierte Schaltung dar, da ein "latch-up"-Effekt ausgelöst werden kann, der im allgemeinen den Ausfall der integrierten Schaltung bedeutet.

Zum Verständnis des "latch-up"-Effekts kann man davon ausgehen, daß zwischen einem Anschluß eines in der wannenförmigen Halbleiterzone liegenden Feldeffekttransistors des ersten Kanaltyps und einem Anschluß eines außerhalb dieser Zone auf dem Halbleitersubstrat plazierten Feldeffekttransistors des zweiten Kanaltyps im allgemeinen vier aufeinanderfolgende Halbleiterschichten alternierender Leitfähigkeitstypen vorhanden sind, wobei das eine Anschlußgebiet des erstgenannten Transistors die erste Halbleiterschicht, die wannenförmige Halbleiterzone die zweite, das Halbleitersubstrat die dritte und das eine Anschlußgebiet des letzteren Transistors die vierte Halbleiterschicht bilden. Bei einer positiven Vorspannung des Halbleitersubstrats kann der pn-Übergang zwischen der dritten und vierten Halbleiterschicht so weit in Durchlaßrichtung vorgespannt werden, daß zwischen den genannten Transistoranschlüssen ein Strompfad entsteht, der auf eine parasitäre Thyristorwirkung innerhalb dieser Vierschichtenstruktur zurückzuführen ist. Der Strompfad bleibt dann auch nach einem Abbau der positiven Substratvorspannung bestehen und kann die integrierte Schaltung thermisch überlasten.

In EP-A-0 142 258 wird eine integrierte Schaltung in komplementärer Schaltungstechnik, bei der das p-Substrat auf eine negative Substratvorspannung liegt, beschrieben. Die Sourcegebiete der im Substrat angeordneten n-Kanal FETs liegen auf Massepotential. Zur Vermeidung von "latch-up"-Effekten ist der Ausgang des Substratvorspannungs-Generators über einen FET mit dem Massepotential verbunden. Der FET wird im Moment des Einschaltens der Versorgungsspannung durch eine Kontrollschaltung in einen leitenden Zustand gebracht.

Der Erfindung liegt die Aufgabe zugrunde, eine Schaltung der eingangs genannten Art anzugeben, bei der das Auftreten von "latch-up"-Effekten weitgehend vermieden wird. Das wird erfindungsgemäß durch eine Ausbildung der Schaltung nach dem kennzeichnenden Teil des Patentanspruchs 1 erreicht.

Die Patentansprüche 2 bis 4 sind auf bevorzugte Ausgestaltungen und Weiterbildungen der Erfindung gerichtet. Der Patentanspruch 5 betrifft eine bevorzugte Anwendung der Erfindung.

Der mit der Erfindung erzielbare Vorteil liegt insbesondere darin, daß eine am Halbleitersubstrat liegende Vorspannung unerwünschter Polarität, die einen "latch-up"-Effekt auslösen kann, mit einfachen Mitteln auf einen Wert begrenzt wird, der diese Gefahr ausschließt.

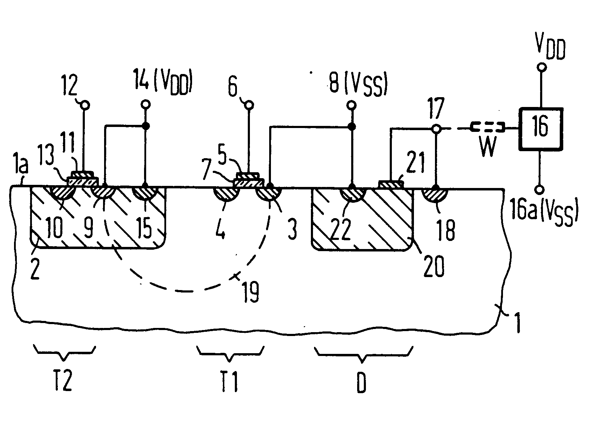

Die Erfindung wird nachfolgend anhand eines in der Zeichnung dargestellten bevorzugten Ausführungsbeispiels näher erläutert.

Dabei ist eine erfindungsgemäße integrierte Schaltung dargestellt, die auf einem Halbleitersubstrat 1 aus dotiertem Halbleitermaterial, zum Beispiel p-leitendem Silizium, aufgebaut ist. Das Substrat 1 weist eine n-leitende, wannenförmige Halbleiterzone 2 auf, die sich bis zur Grenzfläche 1a des Substrats 1 hin erstreckt. Außerhalb der Halbleiterzone 2 sind in das Substrat 1 $n^+$-dotierte Halbleitergebiete 3 und 4 eingefügt, die das Source- und Drain-Gebiet eines n-Kanal-Feldeffekttransistors T1 bilden. Der zwischen 3 und 4 liegende Kanalbereich wird von einem Gate 5 überdeckt, das mit einem Anschluß 6 versehen ist und durch eine dünne elektrisch isolierende Schicht 7, zum Beispiel aus $SiO_2$, von der Grenzfläche 1a getrennt ist. Das Source-Gebiet 3 ist mit einem Anschluß 8 verbunden, der auf einem Massepotential $V_{SS}$ liegt. Weiterhin sind in die Halbleiterzone 2 $p^+$-dotierte Gebiete 9 und 10 eingefügt, welche das Source- und das Drain-Gebiet eines p-Kanal-Feldeffekttransistors T2 darstellen. Der zwischen den Gebieten 9 und 10 liegende Kanalbereich wird von einem Gate 11 überdeckt, das mit einem Anschluß 12 versehen ist und durch eine dünne elektrisch isolierende Schicht 13, zum Beispiel aus $SiO_2$, von der Grenzfläche 1a getrennt ist. Das Source-Gebiet 9 von T2 ist mit einem Anschluß 14 verbunden, der mit einem Versorgungspotential $V_{DD}$ beschaltet ist. Über ein $n^+$-dotiertes Kontaktgebiet 15, das mit dem Anschluß 14 in Verbindung steht, liegt die Halbleiterzone 2 auf der Versorgungsspannung $V_{DD}$.

Weiterhin ist ein Substratvorspannungs-Generator 16 vorgesehen, der eine negative Substratvorspannung von zum Beispiel - 2 bis - 3 Volt erzeugt. Der Ausgang 17 des Substratvorspannungs-Generators ist mit einem $p^+$-dotiertem Kontaktgebiet 18 verbunden, das in das Halbleitersubstrat 1 eingefügt ist. Damit befindet sich das Halbleitersubstrat 1 auf der durch 16 erzeugten negativen Substratvorspannung, während sich die Source-Gebiete, zum Beispiel 3, der im Halbleitersubstrat 1 befindlichen Transistoren, zum Beispiel T1, auf Massepotential $V_{SS}$ befinden. Hierdurch wird unter anderem erreicht, daß die Sperrschichtkapazitäten der Source-Gebiete der im Substrat 1 angeordneten Transistoren verkleinert werden.

Zur Vermeidung eines "latch-up"-Effekts, der innerhalb der entlang der gestrichelten Linie 19 zwischen den Anschlüssen 8 und 14 liegenden Vierschichtenstruktur 3, 1, 2 und 9 auftreten könnte, ist der Ausgang 17 des Substratvorspannungs-Generators 16 über eine Schottky-Diode D mit einem Schaltungspunkt verbunden, der sich auf Massepotential befindet. Beim dargestellten Ausführungsbeispiel entspricht dieser Schaltungspunkt dem Anschluß 8. Ein in das Halbleitersubstrat 1 eingefügter, sich bis zur Grenzfläche 1a erstreckender, n-leitender Halbleiterbereich 20, der eine Dotierungskonzentration von etwa $10^{16}$ $cm^{-3}$ aufweist, ist mit einem Metallkontakt 21 versehen, der zusammen mit dem Halbleiterbereich 20 eine Schottky-Diode darstellt. Der Metallkontakt 21 besteht vorzugsweise aus dem Silizid eines hochschmelzenden Metalls, insbesondere aus Tantalsilizid ($TaSi_2$). Es kommen aber auch andere Materialien in Betracht, die in an sich bekannter Weise für Schottky-Dioden verwendet werden, wie zum Beispiel Platin oder Molybdän. Weiterhin kann der Metallkontakt 21 auch aus Aluminium bestehen oder aus einer Doppelschicht, die eine erste Teilschicht aus dem Silizid eines hochschmelzenden Metalls und eine zweite, oberhalb der ersten liegende Teilschicht aus Aluminium oder AlSi umfaßt. Der Metallkontakt 21 ist mit dem Ausgang 17 des Substratvorspannungs-Generators 16 verbunden, der Halbleiterbereich 20 über ein $n^+$-dotiertes Kontaktgebiet 22 mit dem Anschluß 8.

Die vordere Schwellwertspannung der Schottky-Diode D beträgt etwa 0,2 V, womit sie kleiner ist als die vordere Schwellwertspannung der pn-Übergänge zwischen den Sourcegebieten, zum Beispiel 3, der n-Kanal-Transistoren, zum Beispiel T1, und dem Halbleitersubstrat 1. Liegt nun das Halbleitersubstrat auf einer positiven Vorspannung, die die vordere Schwellwertspannung der Schottky-Diode übersteigt, so leitet diese. Das bedeutet, daß die positive Vorspannung des Halbleitersubstrats 1 auf die vordere Schwellwertspannung von D begrenzt wird. Damit wird aber verhindert, daß die Vorspannung von 1 auf einen solchen Wert ansteigt, daß sie die vordere Schwellwertspannung der pn-Übergänge zwischen den Sourcegebieten der n-Kanal-Transistoren, zum Beispiel T1, und dem Substrat 1 erreicht oder übersteigt, was zu einem "latch-up"-Effekt führen könnte.

Die Klemmwirkung der Schottky-Diode tritt zum Beispiel dann ein, wenn beim Anschalten der Versorgungsspannung $V_{DD}$ das Halbleitersubstrat 1 durch die kapazitive Spannungsteilung zwischen den Anschlüssen 14 und 8 solange auf eine positive Vorspannung angehoben wird, als der Generator 16 noch nicht die volle negative Vorspannung liefert. Erst wenn sich anschließend die negative Vorspannung am Ausgang 17 aufzubauen beginnt, sperrt die Schottky-Diode beim Unterschreiten ihrer vorderen Schwellwertspannung, so daß die beschriebene Klemmwirkung unterbunden wird. Ergeben sich im Betrieb große Ströme, die über das Halbleitersubstrat 1 und die Teile 18, 17 und 16 zum Anschluß 16a, der auf Massepotential $V_{SS}$ liegt, abfließen, so kann am Innenwiderstand W von 16 ein solcher Spannungsabfall entstehen, daß der Ausgang 17 und damit das Halbleitersubstrat 1 zumindest vorübergehend auf eine positive Vorspannung gelangt. Auch in diesem Fall leitet D beim Überschreiten der vorderen Schwellwertspannung, so daß die Spannung an 17 wieder auf die vordere Schwellwertspannung von D begrenzt wird. Diese Klemmwirkung wird unterbunden, sobald sich am Substrat 1 wieder eine negative Vorspannung einzustellen beginnt und dabei die vordere Schwellwertspannung von D unterschritten wird.

Der Substratvorspannungs-Generator 16 ist zweckmäßig auf dem Halbleitersubstrat 1 mit aufintegriert.

Neben den bisher beschriebenen Ausführungsformen umfaßt die Erfindung auch solche, bei denen n-leitende Substrate mit p-leitenden wannenförmigen Halbleiterzonen versehen sind. Dabei werden die Leitungstypen sämtlicher Halbleiterteile und die Polaritäten sämtlicher Spannungen durch die jeweils entgegengesetzten ersetzt. Der Halbleiterbereich 20 entfällt hierbei, so daß der Metallkontakt 21 in diesem Fall das n-leitende Halbleitersubstrat 1 direkt kontaktiert, wobei er nicht mit dem Ausgang 17 des Substratvorspannungs-Generators 16, sondern mit dem auf $V_{SS}$ liegenden Schaltungspunkt 8 verbunden ist.

Eine bevorzugte Anwendung der Erfindung ergibt sich für Peripherieschaltungen von dynamischen Halbleiterspeichern großer Packungsdichte, die mit den Speicherzellen monolithisch integriert sind.

## Patentansprüche

1. Integrierte Schaltung in komplementärer Schaltungstechnik mit Feldeffekttransistoren (T1, T2) unterschiedlicher Kanaltypen, von denen wenigstens ein erster (T1) in einem p-leitenden Halbleitersubstrat (1) und wenigstens ein zweiter (T2) in einer im Halbleitersubstrat vorgesehenen n-leitenden wannenförmigen Halbleiterzone (2) angeordnet sind, wobei die Halbleiterzone (2) mit einer Versorgungsspannung ($V_{DD}$) beschaltet ist, wobei ein Anschlußgebiet (3) wenigstens eines ersten Feldeffekttransistors (T1) mit einem Massepotential ($V_{SS}$) beaufschlagt ist und wobei das Halbleitersubstrat (1) mit dem Ausgang (17) eines eine negative Substratvorspannung erzeugenden Substratvorspannungs-Generators (16) verbunden ist, dem das Massepotential und die Versorgungsspannung zugeführt werden, **dadurch gekennzeichnet**, daß ein in das Halbleitersubstrat (1) eingefügtes n-leitendes Halbleitergebiet (20) mit einem Metallkontakt (21) versehen ist, der mit diesem Halbleitergebiet (20) eine Schottky-Diode (D) bildet, daß der Metallkontakt (21) mit dem Ausgang (17) des Substratvorspannungs-Generators (16) beschaltet ist und daß das Halbleitergebiet (20) mit einem auf Massepotential liegenden Schaltungspunkt (8) verbunden ist.

2. Integrierte Schaltung in komplementärer Schaltungstechnik mit Feldeffekttransistoren (T1, T2) unterschiedlicher Kanaltypen, von denen wenigstens ein erster (T1) in einem n-leitenden Halbleitersubstrat (1) und wenigstens ein zweiter (T2) in einer im Halbleitersubstrat vorgesehenen p-leitenden wannenförmigen Halbleiterzone (2) angeordnet sind, wobei die Halbleiterzone (2) mit einer Versorgungsspannung ($V_{DD}$) beschaltet ist, wobei ein Anschlußgebiet (3) wenigstens eines ersten Feldeffekttransistors (T1) mit einem Massepotential ($V_{SS}$) beaufschlagt ist und wobei das Halbleitersubstrat (1) mit dem Ausgang (17) eines eine positive Substratvorspannung erzeugenden Substratvorspannungs-Generators (16) verbunden ist, dem das Massepotential und die Versorgungsspannung zugeführt werden, **dadurch gekennzeichnet**, daß das Halbleitersubstrat mit einem Metallkontakt versehen ist, der mit dem Halbleitersubstrat eine Schottky-diode (D) bildet, und daß der Metallkontakt mit einem auf Massepotential liegenden Schaltungspunkt (8) verbunden ist.

3. Integrierte Schaltung nach Anspruch 1 oder 2, **dadurch gekennzeichnet**, daß der Substratvorspannungs-Generator (16) auf dem Halbleitersubstrat (1) mit aufintegriert ist.

4. Integrierte Schaltung nach einem der Ansprüche 1 bis 3. **dadurch gekennzeichnet**, daß der Metallkontakt (21) aus dem Silizid eines hochschmelzenden Metalls, insbesondere aus Tantalsilizid, besteht.

5. Integrierte Schaltung nach einem der vorhergehenden Ansprüche, **gekennzeichnet durch** die Anwendung als Peripherieschaltung für dynamische Halbleiterspeicher hoher Integrationsdichte.

## Claims

1. Integrated circuit in complementary circuit technology, comprising field-effect transistors (T1, T2) of different channel types, of which at least a first (T1) is situated in a p-type semiconductor substrate (1) and at least a second (T2) is situated in an n-type well-shaped semiconductor zone (2) provided in the semiconductor substrate, the semiconductor zone (2) being connected to a supply voltage ($V_{DD}$), a terminal region (3) of at least a first field-effect transistor (T1) being connected to an earth potential ($V_{SS}$), and the semiconductor substrate (1) being connected to the output (17) of a substrate bias voltage generator (16) which produces a negative substrate bias voltage and to which the earth potential and the supply voltage are supplied, characterised in that an n-type semiconductor region (20) inserted into the semiconductor substrate (1) is provided with a metal contact (21) which forms a Schottky diode (D) with said semiconductor region (20), in that the metal contact (21) is connected to the output (17) of the substrate bias voltage generator (16), and in that the semiconductor region (20) is connected to a circuit point (8) which is at earth potential.

2. Integrated circuit in complementary circuit technology, comprising field-effect transistors (T1, T2) of different channel types, of which at least a first (T1) is situated in an n-type semiconductor substrate (1) and at least a second (T2) is situated in a p-type well-shaped semiconductor zone (2) provided in the semiconductor substrate, the semiconductor zone (2) being connected to a supply voltage ($V_{DD}$), a terminal region (3) of at least a first field-effect transistor (T1) being connected to an earth potential ($V_{SS}$), and the semiconductor substrate (1) being connected to the output (17) of a substrate bias voltage generator (16) which produces a positive substrate bias voltage and to which the earth potential and the supply voltage are supplied, characterised in that the semiconductor substrate is provided with a metal contact which forms a Schottky diode (D) with the semiconductor substrate, and in that the metal contact is connected to a circuit point (8) which is at earth potential.

3. Integrated circuit according to Claim 1 or 2, characterised in that the substrate bias voltage generator (16) is also integrated on the semiconductor substrate (1).

4. Integrated circuit according to one of Claims 1 to 3, characterised in that the metal contact (21) is composed of the silicide of a refractory metal, in particular of tantalum silicide.

5. Integrated circuit according to one of the preceding claims, characterised by the application of high integration density as peripheral circuit for dynamic semiconductor memories.

**Revendications**

1. Circuit intégré réalisé selon la technique complémentaire des circuits, comprenant des transistors à effet de champ (T1,T2) possédant des types de canaux différents et dont au moins un premier (T1) est disposé dans un substrat semiconducteur (1) à conduction du type p et au moins un second (T2) est disposé dans une zone semiconductrice en forme de cuvette (2) à conduction du type n, prévue dans le substrat semiconducteur, et dans lequel la zone semiconductrice (2) est placée à une tension d'alimentation ($V_{DD}$), une région de raccordement (3) d'au moins un premier transistor à effet de champ (T1) est chargée par un potentiel de masse ($V_{SS}$) et le substrat semiconducteur (l) est raccordé à la sortie (17) d'un générateur de tension de polarisation de substrat (16), qui produit une tension de polarisation de substrat négative et auquel le potentiel de masse et la tension d'alimentation sont appliqués, caractérisé par le fait qu'une région semiconductrice (20) à conduction du type n, insérée dans le substrat semiconducteur (1), est pourvue d'un contact métallique (21), qui forme avec cette région semiconductrice (20) une diode Schottky (D), que le contact métallique (21) est raccordé à la sortie (17) du générateur de tension de polarisation de substrat (16) et que la région semiconductrice (20) est raccordée à un point (8) du circuit, placé au potentiel de masse.

2. Circuit intégré réalisé selon la technique complémentaire des circuits, comprenant des transistors à effet de champ (T1,T2) possédant des types de canaux différents et dont au moins un premier (T1) est disposé dans un substrat semiconducteur (1) à conduction du type p et au moins un second (T2) est disposé dans une zone semiconductrice en forme de cuvette (2) à conduction du type n, prévue dans le substrat semiconducteur, et dans lequel la zone semiconductrice (2) est placée à une tension d'alimentation ($V_{DD}$), une région de raccordement (3) d'au moins un premier transistor à effet de champ (T1) est chargée par un potentiel de masse ($V_{SS}$) et le substrat semiconducteur (1) est raccordé à la sortie (17) d'un générateur de tension de polarisation de substrat (16), qui produit une tension de polarisation de substrat négative et auquel le potentiel de masse et la tension d'alimentation sont appliqués, caractérisé par le fait que le substrat semiconducteur est pourvu d'un contact métallique qui forme avec le substrat semiconducteur une diode Schottky (D), et que le contact métallique est raccordé à un point (8) du circuit, placé au potentiel de masse.

3. Circuit intégré suivant la revendication 1 ou 2, caractérisé par le fait que le générateur de tension de polarisation de substrat (16) est conjointement intégré sur le substrat semiconducteur.

4. Circuit intégré suivant l'une des revendications 1 à 3, caractérisé par le fait que le contact métallique (21) est constitué par le siliciure d'un métal à point de fusion élevé, notamment du siliciure de tantale.

5. Circuit intégré suivant l'une des revendications précédentes, caractérisé par son utilisation en tant que circuit périphérique pour des mémoires dynamiques à semiconducteurs à haute densité d'intégration.